(19) Europäisches Patentamt
European Patent Office
Office européen des brevets

(11) **EP 0 533 253 B1**

(12) **FASCICULE DE BREVET EUROPEEN**

(45) Date de publication et mention
de la délivrance du brevet:
**10.07.1996 Bulletin 1996/28**

(51) Int Cl.⁶: **H03M 7/16**

(21) Numéro de dépôt: **92202776.8**

(22) Date de dépôt: **11.09.1992**

(54) **Procédé de transcodage de données d'un code thermométrique, décodeur et convertisseur appliquant ce procédé**

Datenumkodierungsverfahren für thermometrischen Kode, Dekodierer und Umkodierungseinrichtung zur Anwendung dieses Verfahrens

Data conversion method for a thermometric code, decoder and converter using this method

(84) Etats contractants désignés:
DE FR GB IT NL

(30) Priorité: **20.09.1991 FR 9111645**
**20.09.1991 FR 9111644**

(43) Date de publication de la demande:
**24.03.1993 Bulletin 1993/12**

(73) Titulaires:
• **PHILIPS COMPOSANTS ET SEMICONDUCTEURS**
**92150 Suresnes (FR)**
Etats contractants désignés:
**FR**
• **Philips Electronics N.V.**
**5621 BA Eindhoven (NL)**
Etats contractants désignés:
**DE GB IT NL**

(72) Inventeurs:
• **Le Pailleur, Laurent**
**F-75008 Paris (FR)**

• **Barbu, Stéphane**
**156, Boulevard Haussmann 75008 Paris (FR)**

(74) Mandataire: **Charpail, François et al**
**Société Civile S.P.I.D.**
**156, Boulevard Haussmann**
**75008 Paris (FR)**

(56) Documents cités:
**EP-A- 0 249 538** **EP-A- 0 275 585**

• **PATENT ABSTRACTS OF JAPAN vol. 13, no. 374 (E-808)18 Août 1989 & JP-A-11 026 831**
• **IEEE TRANSACTIONS ON INFORMATION THEORY. vol. 37, no. 4, Juillet 1991, NEW YORK pages 1229 - 1233; A. VAN ZANTEN: 'Index System and Separabilitiy of Constant Weight Gray Codes'**
• **IEEE JOURNAL OF SOLID-STATE CIRCUITS vol. 22, no. 6, Décembre 1987, NEW YORK US pages 944 - 953 R. VAN DE GRIFT ET AL. 'An 8-bit Video ADC Incorporating Folding and Interpolation Techniques'**

## Description

La présente invention a pour objet un procédé de transcodage de données exprimées en mots numériques de même nombre de bits, selon un codage de type thermométrique, dont les valeurs successives peuvent être représentées sous forme d'une première matrice dont chaque ligne est un mot numérique.

Les codes thermométriques sont très fréquemment mis en oeuvre notamment dans les convertisseurs analogiques-numériques, lesquels, du fait des échelles de résistances utilisées pour définir des niveaux de référence pour la comparaison, génèrent des codes thermométriques de manière interne au convertisseur. Un convertisseur analogique-numérique présente alors un convertisseur de code (ou décodeur) dont la fonction est de transformer ledit code thermométrique en un code binaire. Une telle conversion demande un nombre élevé de comparateurs (ou portes), ce qui augmente notablement la surface occupée sur un circuit intégré. La conversion d'un code thermométrique cyclique à mots de $2^N$ bits, en code binaire; requiert environ $2^N$ comparateurs (ou portes). Un tel décodeur est connu du document EP-A-0-249 538.

La présente invention a pour objet un procédé de conversion permettant de transformer un code thermométrique en un code intermédiaire qui peut, quant à lui, être facilement tansformé à son tour en un autre code par exemple en code binaire, de telle sorte que le nombre de comparateurs (ou portes) soit notablement diminué.

L'idée de base de l'invention consiste à tenir compte de la faible densité d'information inhérente aux codes thermométriques pour obtenir un code intermédiaire à plus petit nombre de bits.

Dans ce but, le procédé selon l'invention est caractérisé en ce qu'il utilise un codage intermédiaire défini, d'une part, à partir d'une- deuxième matrice, qui est extraite de la première matrice et dont une dimension est un sous-multiple d'une dimension de la première matrice, et d'autre part, à partir d'une troisième matrice dont les colonnes sont des colonnes particulières de la première matrice, la juxtaposition ligne à ligne des deuxième et troisième matrices permettant de conserver la totalité de l'information présente dans le code thermométrique de départ et formant avec la première matrice une table de conversion définissant le dit codage intermédiaire.

On transforme ainsi la première matrice en un code replié comportant deux matrices faciles à décoder en code binaire, du fait que ce code intermédiaire est plus court et présente à nouveau un caractère thermométrique pour chacune des deuxième et troisième matrices, lesquelles sont au moins en partie cycliques.

Selon un mode particulièrement avantageux, le procédé est caractérisé en ce que la deuxième matrice est constituée à la suite des étapes consistant à :

a) sélectionner dans la première matrice, des sous-matrices dites triangulaires dont les dimensions sont des sous-multiples de celles de la première matrice formant au moins un ensemble de sous-matrices alignées le long d'une diagonale,
b), réaliser la deuxième matrice par un empilement, aligné verticalement, des dites sous-matrices.

On met ainsi à profit la propriété des codes thermométriques, selon laquelle il existe des blocs homogènes soit de "0" soit de "1" séparés par des lignes diagonales de la première matrice lorsqu'elle est relative à un code thermométrique acyclique, ou par des lignes diagonales de chaque moitié de la première matrice lorsqu'elle relative à un code thermométrique cyclique.

Selon une variante préférée, le procédé est caractérisé en ce que la deuxième matrice est rendue au moins en partie cyclique en interposant entre les étapes précitées, une étape supplémentaire consistant à opérer, pour la moitié des sous-matrices et alternativement, une inversion logique des éléments de ces sous-matrices préalablement à leur empilement aligné.

On obtient ainsi un décodage pouvant être simplifié au maximum. La troisième matrice quant à elle, est constituée de colonnes de la première matrice qui ont le même numéro que celui des colonnes des dites sous-matrices triangulaires pour lesquelles tous les éléments sont identiques.

Selon l'invention, le procédé peut également inclure une étape de conversion notamment en code binaire d'au moins une partie des deuxième et troisième matrices du code intermédiaire.

L'invention concerne également un décodeur, mettant en oeuvre le procédé défini précédemment, caractérisé en ce qu'il comporte des moyens de transcodage des signaux d'entrée en un codage intermédiaire conforme à la table de correspondance à trois matrices, lesquels moyens comprennent : dans un premier module de décodage pour le décodage de bits de poids faible du codage binaire de sortie, un premier ensemble de portes réparties en groupes semblables, dits blocs logiques, à k entrées de donnée associées à k entrées de sélection, blocs logiques qui fournissent à leur sortie des signaux exprimant les données d'entrée selon le codage intermédiaire dont les valeurs vérifient la deuxième matrice de la table de conversion, et le nombre k étant égal au nombre de sous-matrices dites triangulaires alignées le long d'une même diagonale de la première matrice,

et dans un deuxième module de décodage pour le décodage de bits de poids fort du codage binaire de sortie, un deuxième ensemble de portes à simple entrée, fournissant en sortie d'autres signaux représentant ceux des bits du signal d'entrée qui ne changent de valeur que lorque l'on passe d'une sous-matrice à une autre au sein de la première matrice, et vérifient la troisième matrice de la table de conversion conformément au codage intermédiaire, deuxième module de décodage qui fournit également des signaux de sélection dont chacun est appliqué à l'une des k entrées de sélection des blocs logiques et qui sont destinés à valider les entrées de données de ces blocs logiques.

En posant les notations N et M telles que :

N est défini par le fait que $2^N$ est égal au nombre de bits du mot numérique à transcoder (code thermométrique de départ),
M est défini par le fait que $2^M$ est égal au nombre des dites sous-matrices triangulaires présentes le long d'une même diagonale de la première matrice,

le nombre d'entrées de donnée et d'entrées de sélection, pour chacun des blocs logiques, est alors égal à $2^M$, et le décodeur, caractérisé en ce que la $p^{ème}$ entrée de sélection de chacun des blocs logiques reçoit le signal logique résultant d'un OU exclusif entre les bits de rang $p.2^{N-M}$ et de rang $(p-1).2^{N-M}$ dans le mot numérique à transcoder, lorsque p prend l'une des valeurs de l'intervalle 2 à $2^M$ (2 et $2^M$ inclus), et le signal logique résultant d'un OU exclusif à sortie inverseuse entre les bits de rang $2^{N-M}$ et de rang $2^N$ dans le mot numérique à transcoder, lorsque p est égal à 1.

Le nombre de blocs logiques peut être choisi égal à $2^{N-M}$, mais dans un mode préféré de réalisation du décodeur selon l'invention, ce nombre de blocs logiques est réduit à $2^{N-M}-1$, ce qui peut être réalisé lorsque le décodeur présente des blocs logiques qui sont agencés de manière que leur $p^{ème}$ entrée de donnée fournisse en sortie un signal logique inversé lorsque la valeur de p est paire, et il se caractérise alors, pour un code thermométrique de départ qui est cyclique, en ce que le nombre de blocs logiques est égal à $2^{N-M}-1$, en ce que la $p^{éme}$ entrée de donnée du $i^{ème}$ bloc logique reçoit les données des bits de rang $(p-1).2^{N-M} + i$ dans le mot numérique à transcoder, pour i variant de 1 à $2^{N-M} - 1$, et en ce que le bit de rang $2^{N-M}$ de la deuxième matrice du code intermédiaire est obtenu en sortie d'une porte OU exclusif recevant en entrée les données logiques égales aux bits de rang N - M + 1 et de rang N + 1 du code binaire qui sont fournis par le deuxième module de décodage.

Lorsque, le code thermométrique est acyclique, le bit de rang $2^{N-M}$ de la deuxième matrice du code intermédiaire est obtenu directement par la valeur du bit de rang N - M + 1 dans le code binaire fourni par le deuxième module de décodage.

La présente invention concerne encore un convertisseur analogique/numérique comportant un décodeur tel que défini précédemment, et qui est caractérisé en ce que les dits blocs logiques sont réalisés sous la forme de portes analogiques à entrées multiples recevant sur des amplificateurs des signaux analogiques différentiels, l'un de ces signaux étant un signal à mesurer, qui est comparé à une pluralité de références, chaque paire de signaux différentiels constituant un équivalent analogique d'un des signaux logiques précédemment mentionnés comme étant appliqués aux entrées de donnée des dits blocs logiques, en ce que chacune de ces portes analogiques inclut des moyens de forçage en niveaux logiques du signal de sortie des dits amplificateurs et des moyens de mémorisation de ces niveaux logiques sur une sortie simple de la dite porte analogique à laquelle les sorties des amplificateurs sont réunies, et en ce que chaque porte analogique est munie d'entrées de sélection pour la validation d'un des amplificateurs, les autres amplificateurs, non sélectionnés, de cette porte présentant un état de haute impédance en sortie.

Un tel convertisseur peut être intégré sous forme de circuit semiconducteur, de structure très compacte.

Un convertisseur selon l'invention peut être agencé de telle sorte que les entrées des amplificateurs des portes analogiques sont connectées à des sorties des réseaux d'interpolation éventuellement reliées à des amplificateurs à repliement.

Ceci permet de simplifier l'architecture de décodage du code thermométrique fourni par les amplificateurs de repliement, lequel est déjà plus simple que le code thermométrique qui correspondrait au signal à échantillonner.

L'invention sera mieux comprise à la lecture de la description qui va suivre, donnée à titre d'exemple non limitatif en liaison avec les dessins qui représentent :

- à la figure 1, une table pour le transcodage de données codées selon un code thermométrique cyclique de 4 bits (équivalent binaire), en un code à deux matrices puis en code binaire,
- à la figure 2, un circuit pour réaliser un tel transcodage,
- à la figure 3, une table pour le transcodage de données se présentant sous un code thermométrique cyclique de 5 bits (équivalent binaire),
- à la figure 4, une représentation des données successives selon un code thermométrique cyclique de N+1 bit (équivalent binaire) à $2^N$ colonnes, pour illustrer le traitement de sous-matrices triangulaires selon l'invention,
- à la figure 5, un convertisseur pour le transcodage de données exprimées en mots de N+1 bit selon un codage thermométrique cyclique, mettant en oeuvre un code intermédiaire selon l'invention,
- à la figure 6, un schéma-bloc représentant schématiquement l'organisation d'un décodeur selon un premier mode de mise en oeuvre de l'invention,

- à la figure 7, un schéma-bloc similaire à celui de la figure 6, mais relatif à un deuxième mode de mise en oeuvre de l'invention et,
- à la figure 8, un schéma électrique pour un exemple de réalisation d'une portion du circuit de la figure 2, dans une technologie à transistors bipolaires.

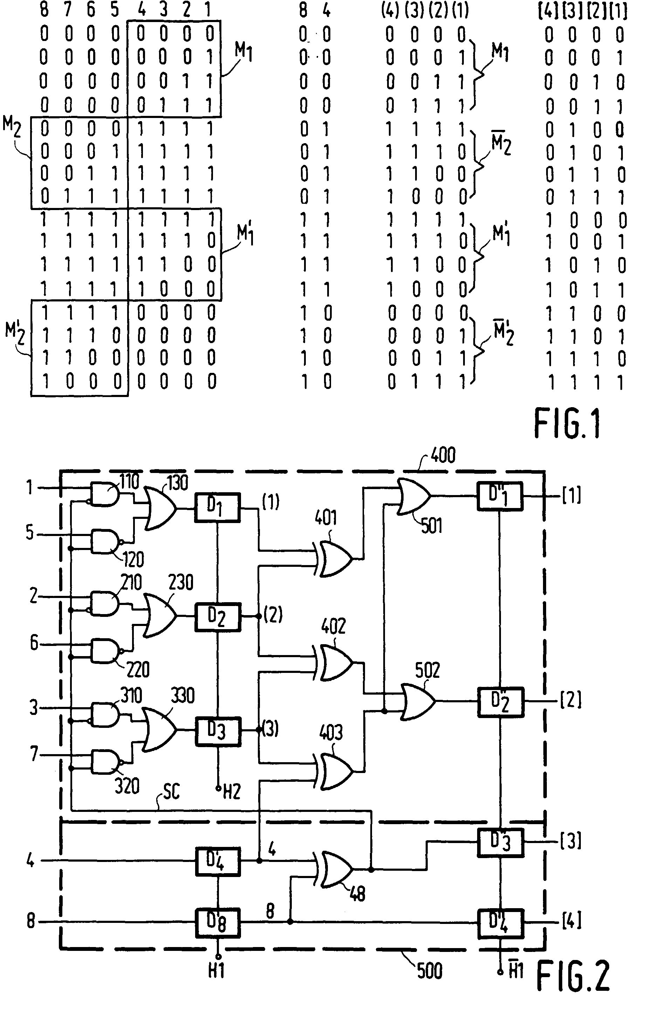

Selon la figure 1, les valeurs successives d'un code thermométrique cyclique exprimées en mots de 8 bits sont représentées par 8 colonnes numérotées de 1 à 8 depuis le bit de poids faible (à droite) jusqu'au bit de poids fort (à gauche), et 16 lignes. La première ligne correspondant à la valeur 0 ne compte que des "0". Les lignes successives de la deuxième à la huitième qui correspondent aux nombres décimaux 1 à 7, voient les "0" des colonnes 1 à 7 progressivement remplacés par des "1". La neuvième ligne ne comporte que des "1" et les lignes successives de la dizième à la seizième, qui correspondent aux nombres décimaux 9 à 15, voient les "1" des colonnes 1 à 7 progressivement remplacés par des "0", la seizième ligne présentant un seul "1" sur la huitième colonne, ce qui assure une continuité cyclique avec la première ligne. Un tel code fait partie de la famille des codes GRAY.

Pour transcoder en binaire, (mot de 4 bits ; N+1 = 4), selon l'art antérieur, il faut $2^3$, soit 8 comparateurs.

On peut voir sur la figure 1 que le code cyclique présente d'assez nombreuses symétries qui ont été mises en évidence en décomposant le code en sous-matrices de 4 lignes et 4 colonnes. 4 de ces sous-matrices seulement sont porteuses d'informations différentes sur chacune des lignes. Elles ont été notées $M_1$, $M_2$, $M'_1$ et $M'_2$. Les sous-matrices $M_1$ et $M_2$ comportent une diagonale de 0 au-dessus de laquelle tous les bits sont des "0" et en dessous de laquelle tous les bits sont des "1". Les sous-matrices $M'_1$ et $M'_2$ comporte une diagonale de 1 au-dessus de laquelle tous les bits valent "1" et au dessous de laquelle tous les bits valent "0". De telles sous-matrices seront appelées "triangulaires" dans la suite de cet exposé. Les autres sous-matrices comportent toutes, soit des "0", soit des "1", c'est-à-dire une seule information. Cette information peut être utilisée pour préciser, pour une donnée déterminée, quelle sous-matrice est concernée. En d'autres termes, cette dernière information permet de distinguer la sous-matrice $M_1$ de la sous-matrice $M_2$, ou encore la sous-matrice $M'_1$ de la sous-matrice $M'_2$, c'est-à-dire de lever l'indétermination entre les sous-matrices identiques. Pour ce faire, la solution la plus simple est d'utiliser directement les colonnes 4 et 8 dont les bits ne changent de valeur que lorsque l'on passe d'une sous-matrice à une autre. On conserve donc la totalité des informations du code thermométrique initial en extrayant l'information des sous-matrices $M_1$ à $M_4$ que l'on aligne verticalement pour former une matrice de code intermédiaire de 4 colonnes et de 16 lignes, à laquelle on ajoute les colonnes 4 et 8 formant une matrice de contrôle du code intermédiaire pour lever l'indétermination. Dans ce qui suit la matrice de code intermédiaire à 4 colonnes sera appelée deuxième matrice tandis que l'ensemble des colonnes 4 et 8 de la matrice du code thermométrique initial sera appelée troisième matrice.

Pour des raisons pratiques d'immunité aux bruits il est avantageux de procéder en inversant les données logiques d'une sous-matrice sur deux, réalisant une substitution de bits, à savoir en remplaçant les données logiques de $M_2$ et de $M'_2$ par leur complément logique. On obtient ainsi une deuxième matrice du code intermédiaire de 4 colonnes notées (1) (2) (3) et (4) et de 16 lignes, en alignant verticalement $M_1$, $\overline{M_1}$, $M'_1$ et $\overline{M_2}'$.

Les huit premières lignes et les huit dernières lignes de cette deuxième matrice sont cycliques, ce qui favorise le décodage ultérieur en binaire. En outre, la quatrième colonne qui a été notée (4) dans la deuxième matrice est dans ce cas, tout à fait particulier, identique à la colonne 4 de la matrice du code thermométrique de départ, dite première matrice. Cette colonne est donc commune à la deuxième matrice et à la troisième matrice.

Il est aisé ensuite de transcoder les données des deux matrices (1) (2) (3) 4 et 8 en une matrice de code binaire [1] [2] [3] et [4]. En effet, les deux parties $M_1$, $\overline{M_2}$, et $M'_1$, $\overline{M_2}'$ forment chacune un code cyclique, ainsi que les colonnes 4 et 8 de la troisième matrice et le décodage se trouve donc simplifié parce qu'il est réalisé sur un plus petit nombre de bits.

La figure 2 représente un décodeur organisé selon la table de conversion des données de la figure 1.

Les bits de la colonne (1) (deuxième matrice) de la matrice de code intermédiaire proviennent des données de la première matrice du code thermométrique cyclique soit de la colonne 1 soit de l'inverse des données de la colonne 5 selon que les données des colonnes 4 et 8 de cette matrice sont identiques ou non. Il en va de manière similaire pour les bits des colonnes (2) (3) de la deuxième matrice. On utilise à cet effet des portes ET 110, 120, 210, 220, 310, 320. Une entrée de ces portes ET reçoit les données logiques correspondant aux colonnes respectivement 1, 5, 2, 6, 3 et 7. Les données logiques correspondant aux colonnes 4 et 8 sont appliquées directement à des bascules de type D respectivement $D'_4$ et $D'_8$ lesquelles sont activées au rythme d'une horloge $H_1$. La sortie de ces bascules $D'_4$ et $D'_8$ est appliquée aux entrées d'une porte OU exclusif 48 dont la sortie fournit un signal de sélection SC et représentatif du fait que les données logiques des colonnes 4 et 8 sont identiques ou non. Une deuxième entrée des portes ET 110 ... 320 sert d'entrée de sélection et reçoit à cet effet le signal de sélection SC issu de la porte 48 et ceci, soit directement (portes 120, 220, 320), soit après inversion (portes 110, 210, 310). Une porte OU 130 a ses entrées connectées à la sortie des portes 110 et 120, une porte OU 230 a ses entrées connectées à la sortie des portes 210 et 220 et une porte OU 330 a ses entrées connectées à la sortie des portes 310 et 320. Pour réaliser l'inversion logique du contenu des sous-matrices $M_2$ et $M'_2$, les portes ET 120, 220 et 320 sont des portes inverseuses en sortie. Lorsque les colonnes 4 et 8 de la première matrice ont des données identiques, la sortie de la porte 48 est au niveau "0" et valide les portes ET 110, 210 et 310. Les données correspondant aux colonnes 1, 2 et 3 de la première matrice sont prises en compte lorsqu'elles concernent les sous-matrices $M_1$ et $M'_1$.

Lorsque les données des colonnes 4 et 8 sont différentes, la sortie de la porte 48 est au niveau logique "1" et valide les portes 120, 220 et 320. Les données correspondant aux colonne 5, 6, et 7 de la première matrice sont prises en compte lorsqu'elles concernent les sous-matrices $M_2$ et $M'_2$.

Les portes OU 130, 230 et 330 délivrent donc des signaux représentatifs des colonnes (1) (2) et (3) de la deuxième matrice du code intermédiaire. La sortie de ces mêmes portes est appliquée à l'entrée de bascules de type D à savoir $D_1$, $D_2$ et $D_3$ rythmées par un signal d'horloge $H_2$. Le front de validation du signal d'horloge $H_2$ est prévu de manière à suivre après un court délai le front de validation du signal d'horloge $H_1$ rythmant les bascules $D'_4$ et $D'_8$ de manière à valider des données en sortie des portes OU 130, 230 et 330 lorsqu'elles ont été stabilisées. Toutefois les signaux d'horloge $H_1$ et $H_2$ passent à l'état de non validation des bascules D de manière synchrone.

Il est à noter dès à présent qu'un ensemble de portes tel que les portes ET 110, 120, la porte OU 130 ainsi que la bascule $D_1$ peuvent être réalisé, en fait, d'une manière très compacte, comme on le verra dans la suite de cet exposé, dans un mode de construction où les entrées logiques telles que l'entrée 1 et l'entrée 5 sont remplacées par leur équivalent analogique. Un tel ensemble sera appelé porte analogique à entrées multiples.

La transformation en code binaire à partir des sorties des bascules $D'_1$, $D'_2$, $D'_3$, $D'_4$ et $D'_8$ est particulièrement aisée en raison des propriétés du code intermédiaire défini ci-dessus. Le bit de poid fort [4] du code binaire est obtenu simplement en prenant directement le bit de donnée correspondant à la colonne 8 de la première matrice représentant le code thermométrique cyclique de départ. Le bit de rang immédiatement inférieur [3] du code binaire est obtenu par un OU exclusif entre les bits des colonnes 4 et 8 à la sortie de la porte OU exclusif 48. Le bit de deuxième rang [2] du code binaire est à "1" soit lorsque les valeurs des colonnes (2) et (3) de la deuxième matrice sont opposées, soit encore, lorsque les valeurs des colonnes (3) et (4) de la même matrice sont opposées. Ainsi, une porte OU exclusif 402 reçoit en entrée les sorties de résultat des colonnes (2) et (3), et une porte OU exclusif 403 reçoit en entrée les sorties de résultat des colonnes (3) et (4) de la deuxième matrice. La sortie de ces portes 402 et 403 est appliquée aux entrées d'une porte OU 502 fournissant le bit de rang [2].

Le bit de rang [1] du code binaire est à "1" lorsque les valeurs des colonnes (1) et (2) d'une part ou des colonnes (3) et (4) d'autre part, de la deuxième matrice, sont opposées. Le bit de rang [1] est donc obtenu à la sortie d'une porte OU 501, qui reçoit sur ses entrées les sorties des portes 401 et 403.

A la figure 2 sont encore représentées des bascules de type D : $D''_1$, $D''_2$, $D''_3$ et $D''_4$ qui sont utiles pour obtenir une bonne synchronisation des résultats codés en binaire. Ces dernières bascules sont rythmées par un signal d'horloge $\overline{H_1}$ qui est l'inverse logique du signal d'horloge $H_1$. Les sorties du résultat binaire sont donc stabilisées durant la partie inactive des signaux d'horloge $H_1$ et $H_2$ qui est commune et synchrone comme on l'a dit précédemment.

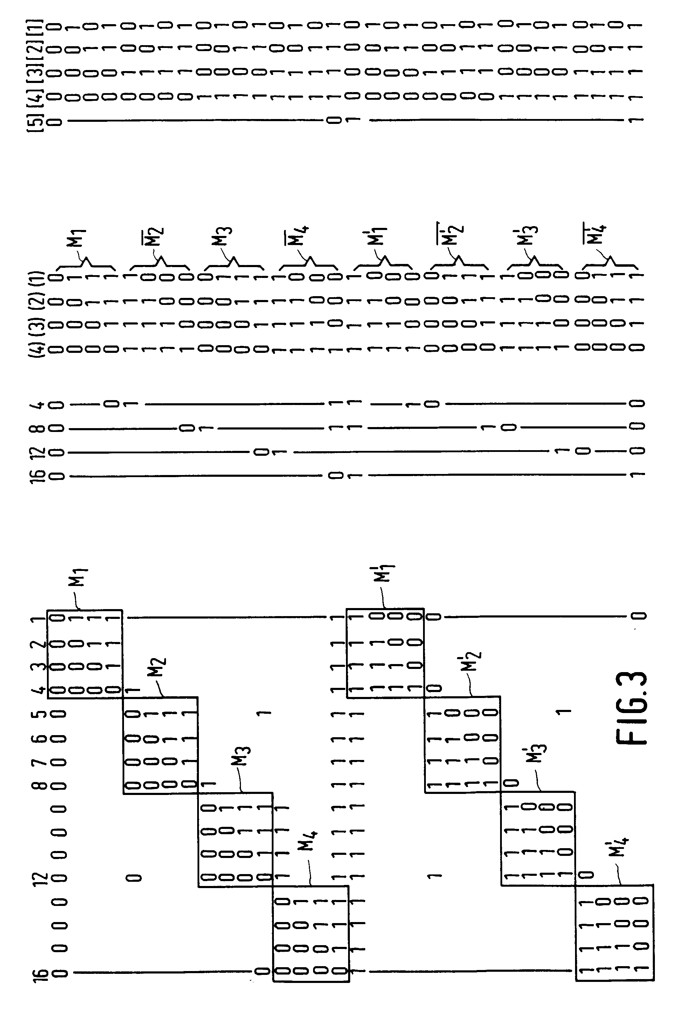

La figure 3 représente la transformation de données exprimées en mots de 16 bits de longueur correspondant à un code thermométrique cyclique à N+1 = 5 bits (dans une évaluation binaire), qui présente $2^N$ colonnes soit 16 colonnes et $2^{N+1}$ lignes soit 32 lignes. On a choisi de comprimer le code à l'aide de sous-matrices dites triangulaires de 4 lignes et 4 colonnes, soit une compression dans un rapport 16/4 = 4. Les quatre premières sous-matrices $M_1$, $M_2$, $M_3$ et $M_4$ présentent une diagonale de "zéro", et les quatre dernières sous-matrices $M'_1$, $M'_2$, $M'_3$ et $M'_4$ une diagonale de "un". Les quatre premières sous-matrices forment ainsi un premier ensemble de sous-matrices triangulaires alignées selon une de leurs diagonales, et les quatre dernières sous-matrices, un deuxième ensemble de sous-matrices triangulaires, alignées selon une de leurs diagonales.

Après transcodage en code intermédiaire, celui-ci présente huit colonnes, les 4 colonnes correspondant aux bits de poids faible sont constituées par alignement vertical des sous-matrices :

$$M_1, \overline{M_2}, M_3, \overline{M_4}, M'_1, \overline{M''_2}, \overline{M''_3}, \overline{M''_4}$$

qui forment les colonnes (1), (2), (3) et (4), de la deuxième matrice formant le code intermédiaire. Les 4 colonnes restantes, 4, 8, 12 et 16 représentent les bits de poids fort et sont utilisées pour lever l'indétermination sur la position de la sous-matrice concernée dans le code cyclique de départ. Ces colonnes correspondent aux colonnes les plus à gauche (vers les bits de poids fort) des sous-matrices triangulaires précitées, car elles possèdent la propriété de voir leur valeur binaire changer sur les diagonales selon lesquelles les matrices sont alignées et donnent donc une information de position.

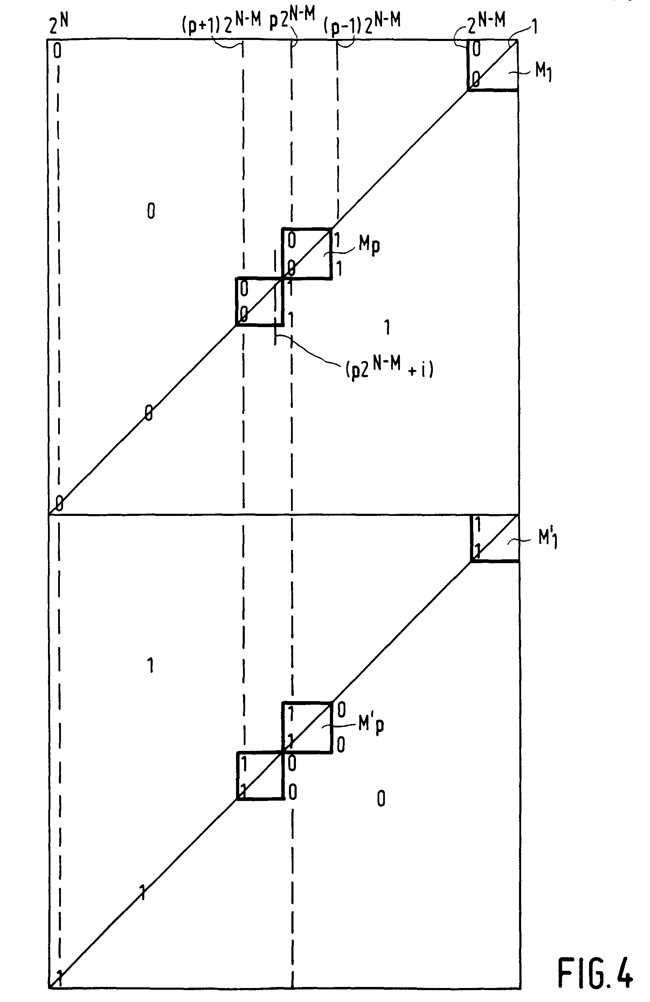

La figure 4 montre la généralisation à un code cyclique à (N + 1) bits (évalué en binaire), soit un code cyclique de départ à $2^N$ colonnes. On décompose chaque diagonale du code initial en $2^M$ sous-matrices triangulaires, chaque sous-matrice triangulaire présentant $2^{N-M}$ lignes et $2^{N-M}$ colonnes. Chaque sous-matrice d'ordre p a sa colonne de droite alignée avec la $[(p-1)2^{N-M}+1]^{ème}$ colonne du code cyclique de départ et sa colonne de gauche alignée avec la $[p2^{N-M}]^{ème}$ colonne du code cyclique de départ, avec p variant de 1 à $2^M$.

En fonction de la propriété des diagonales déjà évoquées ci-dessus, la position d'une sous-matrice de rang p, ($M_P$ ou $M'_p$) peut être définie à partir des valeurs contenues dans les colonnes $p2^{N-M}$ du code cyclique de départ. Après transcodage, le code intermédiaire est alors constitué par l'empilement aligné des sous-matrices :

$M_1, \overline{M_2} ... M_p ... \overline{M_{2^M}}, M^{'}_1, \overline{M^{'}_2}, ... M^{'}_p ... \overline{M^{'}_{2^M}}$
formant ladite deuxième matrice, auquel on adjoint les colonnes p $2^{N-M}$ du code de départ pour p variant de 1 à $2^M$, qui forment ladite troisième matrice.

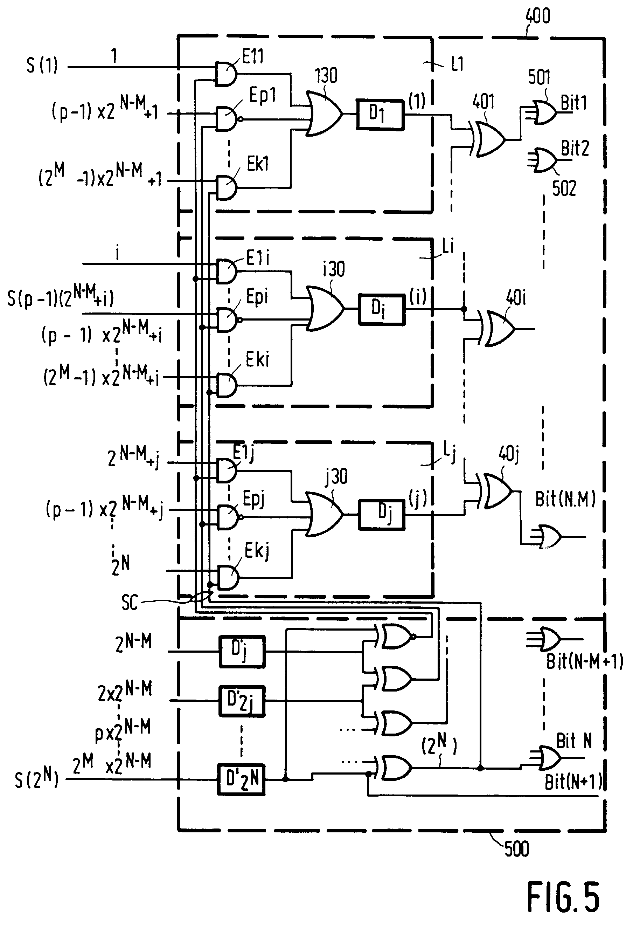

Le décodeur de la figure 5 met en oeuvre la compression d'un code thermométrique de départ en un code intermédiaire tel que défini précédemment, code intermédiaire dont les valeurs successives se présentent sous la forme d'une seconde matrice ainsi que d'une troisième matrice permettant la sélection des données de la deuxième matrice. En généralisant ce qui précède, on remarque qu'une donnée de la colonne (i) de la deuxième matrice du code intermédiaire est obtenue à partir des fractions ad hoc des colonnes :

i, $2^{N-M}+i$,..., $[(p-1)2^{N-M}+i]$, ..., $[(2^M-1)2^{N-M}+i]$ de la première matrice, i variant de 1 à $2^{N-M}$, et en fonction des informations contenues dans les colonnes $2^{N-M}$, $2.2^{N-M}$ ..., $p.2^{N-M}$, ..., $2^N$, pour p variant de 1 à $2^M$.

Le décodeur de la figure 5 met donc en oeuvre $2^{N-M} = j$ blocs logiques ou portes analogiques équivalentes notés $L_1 ... L_i ... L_j$, comportant chacun $2^M$ cellules d'entrée notées $E_{1i} ... E_{Pi} ... E_{ki}$, $(k = 2^M)$ dont les sorties sont connectées à une entrée de portes OU à $2^M$ entrées notées respectivement 130,... i30,... j30. Comme on le verra par la suite, lesdites cellules d'entrée $E_{Pi}$ peuvent dans une variante non représentée sur la figure 5 prendre la forme de portes analogique à $2^M$ entrées de signal analogique et $2^M$ entrées de sélection, auquel cas les portes OU 130, i30 et j30 peuvent être supprimées lorsque de telles portes analogiques présentent des sorties à haute impédance correspondant aux entrées non sélectionnées. On verra également par la suite que la bascule D pour la mémorisation des données de sortie de chacun des blocs $L_1 ... L_i ... L_j$, peut faire partie intégrante de telles portes analogiques.

Le bloc logique $L_i$ reçoit sur ses entrées de données les données de la $(p-1).2^{N-M}+i^{ème}$ colonne du code cyclique de départ. Il reçoit par ailleurs sur une autre entrée dite de sélection, un signal qui fait partie d'un groupe de signaux de contrôle SC et qui est le résultat d'un OU exclusif entre les colonnes $p.2^{N-M}$ successives pour p variant de 1 à $2^M$. On complète la série des signaux SC avec la sortie d'un OU exclusif inversé recevant en entrée les données des colonnes notées $2^{N-M}$ et $2^N$ de la troisième matrice.

Pour réaliser l'inverse logique des sous-matrices dites triangulaires (sous-matrices de rang pair) les cellules d'entrée $E_{pi}$ sont inverseuses en sortie lorsque p est pair.

Dans la version de construction à l'aide de portes analogiques à entrées multiples dont il a été déjà question et qui seront décrites ultérieurement, le nombre de ces portes analogiques s'élève seulement à $2^{N-M}$ et non plus $2^N$ comme dans l'art antérieur à quoi on ajoute $2^M$ portes pour l'entrée des données de poids fort pour obtenir le code intermédiaire de l'invention à partir d'un code thermométrique cyclique. Les $2^M$ portes OU exclusif utilisées pour le décodage des poids forts du code binaire servent également à la sélection des entrées des blocs logiques (ou des portes analogiques équivalentes) décodant les poids faibles. Le passage du code intermédiaire de l'invention au code binaire ne demande pas de comparateur supplémentaire mais seulement des portes OU et/ou des portes OU exclusif.

On a donc besoin de moins de comparateurs que dans le cas d'un décodeur classique pour le décodage de données exprimées en code thermométrique, à savoir $2^N$ comparateurs.

Selon une variante avantageuse déjà utilisée dans le schéma de la figure 2, un bloc logique ou son équivalent en portes analogiques à entrées multiples peut être économisé. Il s'agit du bloc noté $L_j$ correspondant au traitement de la colonne $2^{N-M}$ de la deuxième matrice du code intermédiaire. En effet, les données correspondantes sont redondantes avec les informations contenues dans la troisième matrice du code intermédiaire. Ainsi qu'on le verra ci-après, cette propriété est généralisable dans tous les cas de sorte qu'on aboutit au besoin de $2^{N-M} + 2^M-1$ comparateurs nécessaires, c'est-à-dire un de moins que ce qui a été indiqué précédemment. Ce nombre de comparateurs est bien évidemment très inférieur à $2^N$, nombre qui était nécessaire selon l'art antérieur.

<u>Exemples</u> :

I) N + 1 = 4 (code à 4 bits équivalents binaire)

    1) $2^N = 8$, soit 8 comparateurs pour le décodage selon l'art antérieur.
    2) M = 1
        $2^{N-M} + 2^M-1 = 4 + 2 - 1 = 5$ comparateurs pour le décodage selon l'invention. On obtient un résultat appréciable même pour ce faible nombre de bits.

II) N + 1 = 10 (code à 10 bits équivalents binaires)

    1) $2^N = 512$ soit 512 comparateurs pour le décodage selon l'art antérieur.
    2) M = 2
        $2^{N-M} + 2^M-1 = 128 + 4 - 1 = 131$ comparateurs pour le décodage selon l'invention.
    3) M = 3 3
        $2^{N-M} + 2^M-1 = 64 + 8 - 1 = 71$ comparateurs pour le décodage selon l'invention.

4) M = 4

$2^{N-M} + 2^M - 1 = 32 + 16 - 1 = 47$ comparateurs pour le décodage selon l'invention.

5) M = 5

$2^{N-M} + 2^M - 1 = 16 + 32 - 1 = 47$ comparateurs.

Dans le cas d'un convertisseur à repliement et interpolation, la taille du décodeur des bits de poids fort est préférablement inférieure à celui du décodeur des bits de poids faible.

Il en résulte que $2^M \leq 2^{N-M} - 1$.

L'optimum est obtenu pour M choisi le plus grand possible mais inférieur ou égal à N/2. Si N est pair, on choisit M = N/2. Si N est impair, on choisit M = N/2 - 0,5.

Dans l'exemple ci-dessus, le cas n°5 (N = 9, M = 5) n'est pas intéressant. L'optimum est le cas n°4 (M = 4) avec 47 comparateurs au lieu des 512 de l'art antérieur.

A l'aide de la figure 5, on va établir comment on peut transcoder les données du code intermédiaire à deux matrices en données exprimées selon le code binaire classique. Le décodeur de la figure 5 est relatif à un exemple dans lequel les données de départ sont exprimées en mots numériques de $2^N$ bits dans un codage de type thermométrique cyclique (code à (N+1) bits équivalent binaire). On considère à cet effet quelles sont les portes OU exclusif telles que les portes 401, ... 40i ... 40j qui donnent lieu à l'apparition d'un bit de validation à "1" (bit q = 1) dans le codage binaire, puis de faire la sommation logique de ces cellules. En complément, une opération analogue est effectuée sur les sorties des portes OU exclusif qui, après traitement de la troisième matrice, génèrent les signaux de sélection SC.

Le décodeur de la figure 5 comporte donc un premier module de décodage pour les bits de poids faible (400) et un deuxième module de décodage pour les bits de poids fort (500). Le deuxième module de décodage 500 auquel sont associées les entrées logiques $D'_j$ ... $D'_{2^N}$ fournit des signaux logiques SC en tant que signaux de sélection pour les blocs logiques $L_1$ à $L_j$ à l'entrée du module de décodage 400. Chaque partie des modules de décodage 400 et 500 ayant pour objet de transformer en codage binaire des données présentées sous la forme du code intermédiaire, de nature thermométrique, reste classique et connue en soi bien que les signaux traités par le module de décodage 500 soient des signaux qui sont spécifiques de l'invention. La construction de ces parties du décodeur fait appel à des portes OU exclusif et des portes OU.

On peut remarquer qu'il existe deux façons d'obtenir les données de la colone de rang $2^{N-M}$ de la deuxième matrice du code intermédiaire. Il existe en effet une certaine redondance entre les informations qui sont contenues dans la colonne de rang $2^{N-M}$ de la deuxième matrice et les informations provenant des colonnes de la troisième matrice.

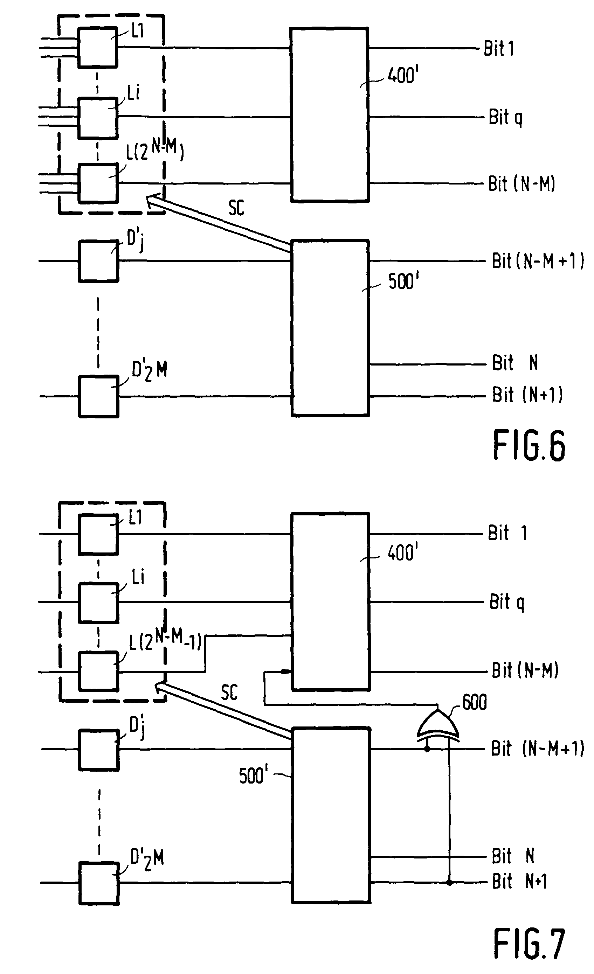

Selon la figure 6 qui reprend de manière schématique le décodeur de la figure 5, le nombre de blocs logiques $L_1$ ... $L_j$ s'étend jusqu'à la valeur $j = 2^{N-M}$. Le sous-module de décodage de poids faible 400' fournit le décodage en binaire de tous les bits de poids faible jusqu'au bit N-M binaire. Le sous-module de décodage 500' fournit pour sa part les signaux de sélection SC pour la validation convenable des entrées des blocs logiques $L_1$ à $L_j$.

Plus précisément, la $p^{\text{ème}}$ entrée de sélection de chacun des blocs logiques reçoit le signal logique résultant d'un OU exclusif entre les bits de rang $p.2^{N-M}$ et de rang $(p-1).2^{N-M}$ dans le mot numérique à transcoder, lorsque p prend l'une des valeurs de l'intervalle 2 à $2^M$ (bornes comprises), et le signal logique résultant d'un OU exclusif à sortie inverseuse entre les bits de rang $2^{N-M}$ et de rang $2^N$ dans le mot numérique à transcoder, lorsque p est égal à 1. Dans ce cas, la $p^{\text{ème}}$ entrée de donnée du $i^{\text{ème}}$ bloc logique reçoit les données des bits de rang $(p-1).2^{N-M} + i$ dans le mot numérique à transcoder, pour i variant de 1 à $2^{N-M}$.

Selon une variante de réalisation préférée représentée à la figure 7, un des blocs logiques est omis et le nombre de ces blocs ne s'étend plus que de $L_1$ jusqu'à $L_{(2^{N-M}-1)}$. Le bloc logique d'indice $2^{N-M}$ est économisé et le bit de colonne $2^{N-M}$ de la deuxième matrice du code intermédiaire est alors manquant. Il sera toutefois fourni au sous-module de décodage 400' à l'aide d'une porte OU exclusif 600 recevant en entrée les bits (N-M+1) et (N+1) du code binaire qui sont produits par le sous-module de décodage de poids forts 500'. Ainsi une partie du décodage des poids forts est mise à profit pour décoder certains bits des poids faibles. Toutefois ceci s'applique lorsque le décodeur est agencé avec des blocs logiques tels que leur p ème entrée de donnée fournisse en sortie un signal logique inversé lorsque la valeur de p est paire. Alors, lorsque le code thermométrique de départ est cyclique, la $p^{\text{ème}}$ entrée de donnée du $i^{\text{ème}}$ bloc logique reçoit les données des bits de rang $(p-1).2^{N-M} + i$ dans le mot numérique à transcoder, pour i variant de 1 à $2^{N-M} - 1$, et le bit de rang $2^{N-M}$ de la deuxième matrice du code intermédiaire est obtenu en sortie d'une porte OU exclusif recevant en entrée les données logiques égales aux bits de rang N - M + 1 et de rang N + 1 du code binaire qui sont fournis par le deuxième sous-module de décodage 500'.

Lorsque les données se présentent sous un codage thermométrique acyclique et dans un décodeur présentant à nouveau des blocs logiques qui sont agencés de manière que leur p ème entrée de donnée fournisse en sortie un signal logique inversé lorsque la valeur de p est paire, le nombre de blocs logiques étant réduit à $2^{N-M}-1$ la $p^{\text{ème}}$ entrée de donnée du $i^{\text{ème}}$ bloc logique reçoit les données des bits de rang $(p-1).2^{N-M} + i$ dans le mot numérique à transcoder, pour i variant de 1 à $2^{N-M}-1$, et le bit de rang $2^{N-M}$ de la deuxième matrice du code intermédiaire est obtenu directement par la valeur du bit de rang N - M + 1 dans le code binaire fourni par le deuxième sous-module de décodage 500'.

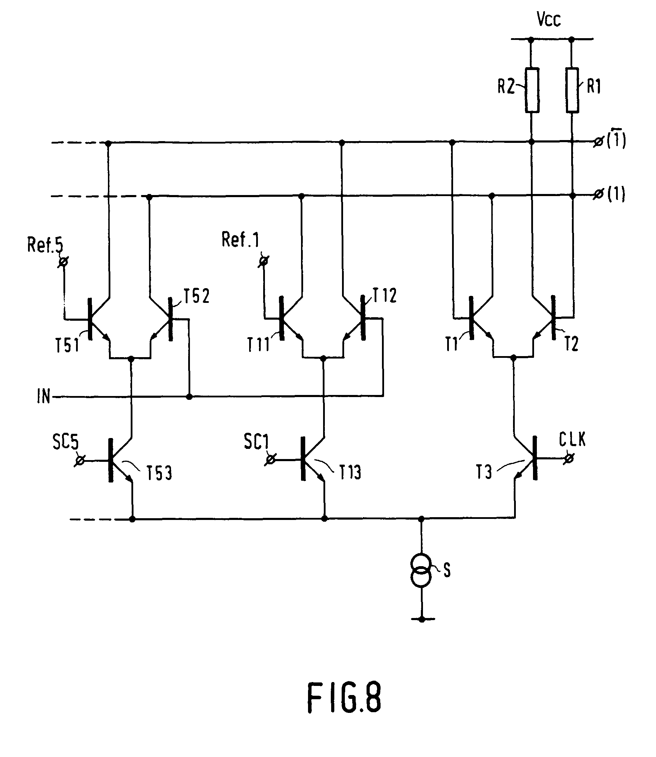

La figure 8 fournit un schéma électrique d'un exemple de réalisation d'une portion de circuit de la figure 2, dans une technologie à transistors bipolaires. A la figure 2, les portes ET 110, 120, la porte OU 130 et la bascule D1 forment un groupe de portes appelé bloc logique, par la suite, lors de la description des figures 5, 6 et 7. Un équivalent pour des signaux d'entrée analogiques est réalisé ici d'une manière particulièrement économique utilisant l'aiguillage d'un seul courant fourni par une source de courant S.

Cette source S alimente à partir de la borne de référence (masse), le trajet émetteur-collecteur de trois transistors T3, T13 et T53, l'un seulement de ces transistors étant conducteur à un instant donné, sous l'effet de signaux de commande appropriés : CLK, SC1 et SC5. Le signal CLK est un signal d'horloge prioritaire par rapport aux signaux SC1 et SC5, ces deux derniers étant prévus pour n'être actifs qu'un seul à la fois comme cela a été montré précédemment à propos des signaux de commande SC.

Les signaux analogiques aux entrées notées Ref1 et Ref5 correspondent à des signaux de références à comparer avec un signal IN à mesurer. Ces comparaisons sont effectuées par deux amplificateurs différentiels constitués par les paires de transistors T11, T12 et T51, T52 dont les courants collecteur fournissent des signaux de sortie (1) et $(\bar{1})$ sur des résistances de charge R1 et R2, qui sont connectées par ailleurs à la tension d'alimentation positive Vcc. Conformément au schéma des portes 110 et 120 de la figure 2, le signal différentiel de sortie de l'amplificateur T11, T12 est inversé logiquement par rapport à celui de l'amplificateur T51, T52.

Le transistor T3 commandé par le signal CLK, alimente une paire de transistors T1, T2 dont les collecteurs sont connectés respectivement aux résistances de charge R1 et R2, et dont les bases sont couplées de manière croisée avec les collecteurs. Au moment où le transistor T3 devient conducteur, le signal différentiel sur les sorties (1) et $(\bar{1})$ est confirmé en niveaux logiques (complémentaires) et maintenu dans cet état durant la validation du signal CLK. Il est à remarquer que dans ce montage, les fonctions équivalentes aux portes 110, 120, ainsi que la fonction de mémorisation (bascule D1) telles que montrées à la figure 2, sont réalisées ici de manière simple et compacte. La porte OU 130 de la figure 2 se réduit ici à un noeud de connexions.

Dans le cas où les entrées analogiques à combiner seraient en nombre plus élevé que les deux de l'exemple décrit, il suffit simplement d'ajouter trois transistors supplémentaires par entrée supplémentaire, à savoir : un transistor d'aiguillage de courant Tx3, (homologue des transistors T13, T53), commandé par un signal de sélection SCx ainsi qu'une paire différentielle Tx1, Tx2 (homologue des paires T11, T12 ; T51, T52) recevant son signal analogique IN sur une entrée à comparer avec un signal de référence Refx. Une telle possibilité a été symbolisée à la figure 8 par la prolongation en tirets des lignes communes à ces éléments.

Un résultat très important du point de vue pratique est obtenu avec le montage qui vient d'être décrit du fait que la consommation de courant de la porte analogique est fixée par la source de courant S et reste indépendante du nombre d'entrées. La porte analogique à entrées multiples de la figure 8 est intégrable de façon simple et compacte. Elle peut être alimentée en entrée aussi bien par des signaux à niveaux logiques que par des signaux analogiques. Elle inclut des moyens de forçage en niveaux logiques du signal de sortie ainsi que des moyens de mémorisation de ces niveaux logiques qui sont comparables à l'effet d'une bascule de type D. Un seul amplificateur constitué d'une paire différentielle de transistors n'est validé à la fois les autres amplificateurs de la même porte analogique ayant leur sortie dans un état à haute impédance.

Il est à noter que les entrées d'une telle porte analogique peuvent être connectées à des sorties des réseaux d'interpolation éventuellement reliés à la sortie d'amplificateurs à repliement dans un convertisseur analogique-numérique. Pour plus de renseignements sur ce type de convertisseurs connus, on se reportera à l'article "A 8-bit Video ADC Incorporating Folding and Interpolation Techniques" de Rob Van de Grift et al (IEEE Journal of Solid State Cicuits, vol.SC-22, n°6, Dec 1987, p.944-953), dont le contenu est incorporé, par référence, à la présente description.

Bien entendu, le schéma de la figure 8 ne représente qu'un exemple selon une technologie à transistors bipolaires alors que l'invention est nettement plus générale et peut s'appliquer pour la réalisation de décodeurs et de convertisseurs construits dans d'autres technologies, à transistors à effet de champ par exemple.

D'autre part, le code intermédiaire défini dans l'invention présente au moins des portions à caractère thermométrique, il peut donc être soumis lui-même à une nouvelle compression selon le procédé décrit, aboutissant à un code intermédiaire second fournissant des mots numériques à nombre de bits encore plus réduit. Une telle itération du procédé de l'invention peut être opérée plusieurs fois. Dans des applications où les mots du code thermométrique de départ ont un nombre de bits très élevé, une itération du procédé peut être avantageuse bien qu'elle augmente le nombre de couches de portes logiques travaillant en série.

Les équations logiques correspondant au procédé de transcodage selon l'invention, aboutissant à un code binaire en sortie, vont maintenant être données. Pour introduire les notations, on donne d'abord l'équation logique permettant le transcodage d'un code thermométrique acyclique en code binaire sans passer par le code intermédiaire prévu dans l'invention. La valeur du bit de poids q du code binaire peut s'obtenir par :

$$\text{Bit } q = \sum_{p=1}^{2^{N-q}} \left[ \sum_{i=1}^{2^{q-1}} D_{(p.2^q-i)} \oplus D_{(p.2^q-i+1)} \right]$$

$D(x)$ représente la valeur du bit de rang x dans le code thermométrique,

$\Sigma$ désigne la sommation logique (fonction logique OU),

$\theta$ désigne un OU exclusif.

Le transcodage en code binaire utilisant le code intermédiaire conforme à l'invention peut être décrit en considérant les cas suivants :

a) pour $1 \le q \le$ N-M (les N-M bits de poids faibles du code binaire) :

$$\text{Bit } q = \sum_{p=1}^{2^{N-M-q}} \left[ \sum_{i=1}^{2^{q-1}} D_{(p.2^q-i)} \oplus D_{(p.2^q-i+1)} \right]$$

$D(x)$ désignant maintenant la valeur logique en sortie du $x^{ème}$ bloc logique $L_1,... L_i,... L_j$ (figure 5), c'est-à-dire la $x^{ème}$ colonne de la 2e matrice du code intermédiaire. L'équation a la même forme que précédemment du fait que chaque sous-matrice triangulaire du code de départ est elle-même de nature thermométrique.

b) pour $1+$N-M $\le q \le$ N (les M bits de poids forts du code binaire) :

$$\text{Bit } q = \sum_{p=1}^{2^{N-q}} \left[ \sum_{i=1}^{2^{q-N+M-1}} D'_{(p.2^{q-N+M}-i).2^{N-M}} \oplus D'_{(p.2^{q-N+M}-i+1).2^{N-M}} \right]$$

$D'(x)$ désignant la valeur logique en sortie de la $x^{ème}$ bascule $D'_j ... D'_k ... D'_{2N}$ qui correspond aux valeurs des colonnes successives de la $3^{ème}$ matrice du code intermédiaire (poids forts).

Quand les données de départ sont sous la forme d'un code thermométrique cyclique à $2^N + 1$ bits,

c) Bit N+1 = $D'_{2N}$ c'est-à-dire le bit de la colonne notée $2^N$ de la $3^{ème}$ matrice.

On retrouve bien ici que les bits du code binaire sont obtenus en sortie de portes OU à entrées multiples (501, 502...) recevant des sorties de OU exclusif (401 ... 40j), (figure 5), donc sans ajouter de comparateurs.

## Revendications

1. Procédé de transcodage de données exprimées en mots numériques de même nombre ($2^N$) de bits, selon un codage de type thermométrique, dont les valeurs successives peuvent être représentées sous forme d'une première matrice dont chaque ligne est un mot numérique,

   caractérisé en ce qu'il utilise un codage intermédiaire défini, d'une part, à partir d'une deuxième matrice ($M_1, \overline{M_2},...$ $M'_2, \overline{M'_2}...$), qui est extraite de la première matrice et dont une dimension est un sous-multiple d'une dimension de la première matrice, et d'autre part, à partir d'une troisième matrice dont les colonnes sont des colonnes particulières de la première matrice, la juxtaposition ligne à ligne des deuxième et troisième matrices permettant de conserver la totalité de l'information présente dans le code thermométrique de départ et formant avec la première matrice une table de conversion définissant le dit codage intermédiaire.

2. Procédé selon la revendication 1,

   caractérisé en ce que la deuxième matrice est constituée à la suite des étapes consistant à :

   a) sélectionner dans la première matrice, des sous-matrices ($M1, M_2, ... M'_1, M'_2...$) dites triangulaires dont les dimensions sont des sous-multiples de celles de la première matrice formant au moins un ensemble de sous-matrices alignées le long d'une diagonale,

   b) réaliser la deuxième matrice par un empilement, aligné verticalement, des dites sous-matrices.

**3.** Procédé selon la revendication 2,
caractérisé en ce que la deuxième matrice est rendue au moins en partie cyclique en interposant entre les étapes précitées, une étape supplémentaire consistant à opérer, pour la moitié des sous-matrices ($M_2$, $M_4$, ... $M'_2$, $M'_4$...) et alternativement, une inversion logique des éléments de ces sous-matrices préalablement à leur empilement aligné.

**4.** Procédé selon l'une des revendications 1 à 3,
caractérisé en ce que les (4, 8, 12, 16) de la troisième matrice sont celles de la première matrice qui ont le même numéro que celui des colonnes des dites sous-matrices triangulaires pour lesquelles tous les éléments sont identiques.

**5.** Procédé selon l'une des revendications 1 à 4,
où N est défini par le fait que $2^N$ est égal au nombre de bits du mot numérique à transcoder (code thermométrique de départ),
M est défini par le fait que $2^M$ est égal au nombre des dites sous-matrices triangulaires ($M_1$, $M_2$, ... $M'_1$,$M'_2$...) présentes le long d'une même diagonale de la première matrice,
caractérisé en ce que pour le transcodage d'un mot numérique en code binaire, un bit de rang q du code binaire (Bit q) résulte des opérations logiques suivantes :

a) pour $1 \leq q \leq N-M$ c'est à dire les (N-M) bits de poids faibles du code binaire

$$\text{Bit } q = \sum_{p=1}^{2^{N-M-q}} \left[ \sum_{i=1}^{2^{q-1}} D_{(p.2^q-i)} \oplus D_{(p.2^q-i+1)} \right]$$

$D_{(X)}$ désignant la donnée contenue dans la colonne de rang x de la première matrice,
b) pour $1 + N-M \leq q \leq N$ c'est à dire les M bits de poids forts du code binaire

$$\text{Bit } q = \sum_{p=1}^{2^{N-q}} \left[ \sum_{i=1}^{2^{q-N+M-1}} D'_{(p.2^{q-N+M}-i).2^{N-M}} \oplus D'_{(p.2^{q-N+M}-i+1).2^{N-M}} \right]$$

$D'_{(X)}$ désignant les données contenues dans la colonne de rang x de la troisième matrice,
c) et pour le cas où le code thermométrique de départ à $2^N$ bits est cyclique, le $N+1^{ème}$ bit du code binaire est obtenu directement par :

$$\text{Bit } N + 1 = D'_{(2^N)}.$$

c'est-à-dire le bit dont le poids est le plus fort dans le mot numérique à transcoder.

**6.** Décodeur pour la mise en oeuvre du procédé selon l'une des revendications 1 à 5, caractérisé en ce qu'il comporte des moyens de transcodage des signaux d'entrée en un codage intermédiaire, dans lequel une deuxième matrice ($M_1,\overline{M_2}$, ..., $M'_1$, $\overline{M'_2}$) est extraite de la première matrice et a une dimension sous-multiple d'une dimension de la première matrice et dans lequel une troisième matrice a des colonnes constituées de colonnes particulières de la première matrice lesquels moyens comprennent : dans un premier module de décodage (400) pour le décodage de bits de poids faible du codage binaire de sortie, un premier ensemble de portes (110, 120, 130, D1, 210, 220, 230, D2 ...) réparties en groupes semblables, dits blocs logiques ($L_1$,...$L_i$...$L_j$), à k entrées de donnée associées à k entrées de sélection, blocs logiques qui fournissent à leur sortie des signaux exprimant les données d'entrée selon le codage intermédiaire dont les valeurs vérifient la deuxième matrice et le nombre k étant égal au nombre de sous-matrices ($M_1$, $M_2$,...$M'_1$, $M'_2$,...) dites triangulaires, parmi lesquelles sont extraites des sous-matrices de la deuxième matrice, alignées le long d'une même diagonale de la première matrice représentant le code thermométrique,
et dans un deuxième module de décodage (400) pour le décodage de bits de poids fort du codage binaire de sortie, un deuxième ensemble de portes ($D'_4$, $D'_8$ ,... $D'_j$,...) à simple entrée, fournissant en sortie d'autres signaux représentant ceux des bits du signal d'entrée qui ne changent de valeur que lorsque l'on passe d'une sous-matrice à une autre au sein de la première matrice, et vérifient la troisième matrice de la table de conversion conformément au codage intermédiaire, deuxième module de décodage qui fournit également des signaux de sélection (SC) dont chacun est appliqué à l'une des k entrées de sélection des blocs logiques ($L_1$,...$L_i$...$L_j$) et qui

sont destinés à valider les entrées de données de ces blocs logiques.

7. Décodeur selon la revendication 6,
   caractérisé en ce que la $p^{ème}$ entrée de sélection de chacun des blocs logiques (Li) reçoit le signal logique résultant d'un OU exclusif entre les bits de rang $p.2^{N-M}$ et de rang $(p-1).2^{N-M}$ dans le mot numérique à transcoder, lorsque p prend l'une des valeurs de l'intervalle 2 à $2^M$, 2 et $2^M$ inclus, et le signal logique résultant d'un OU exclusif à sortie inverseuse entre les bits de rang $2^{N-M}$ et de rang $2^N$ dans le mot numérique à transcoder, lorsque p est égal à 1, et pour N et M tels que définis à la revendication 5.

8. Décodeur selon la revendication 7,
   caractérisé en ce que le nombre de blocs logiques (Li) est égal à $2^{N-M}$, et en ce que la $p^{ème}$ entrée de donnée du $i^{ème}$ bloc logique reçoit les données des bits de rang $(p-1).2^{N-M} + i$ dans le mot numérique à transcoder, pour i variant de 1 à $2^{N-M}$.

9. Décodeur selon la revendication 7, pour le transcodage de données se présentant sous un codage thermométrique cyclique et lequel décodeur présentant des blocs logiques (Li) qui sont agencés de manière que leur p ème entrée de donnée fournisse en sortie un signal logique inversé lorsque la valeur de p est paire,
   caractérisé en ce que le nombre de blocs logiques est égal à $2^{N-M}-1$, en ce que la $p^{ème}$ entrée de donnée du $i^{ème}$ bloc logique reçoit les données des bits de rang $(p-1).2^{N-M} + i$ dans le mot numérique à transcoder, pour i variant de 1 à $2^{N-M} - 1$, et en ce que le bit de rang $2^{N-M}$ de la deuxième matrice du code intermédiaire est obtenu en sortie d'une porte OU exclusif recevant en entrée les données logiques égales aux bits de rang $N - M + 1$ et de rang $N + 1$ du code binaire qui sont fournis par le deuxième module de décodage (500)

10. Décodeur selon la revendication 7, pour le transcodage de données se présentant sous un codage thermométrique acycliques et lequel décodeur présentant des blocs logiques (Li) qui sont agencés de manière que leur p ème entrée de donnée fournisse en sortie un signal logique inversé lorsque la valeur de p est paire,
    caractérisé en ce que le nombre de blocs logiques (Li) est égal à $2^{N-M}-1$, en ce que la $p^{ème}$ entrée de donnée du $i^{ème}$ bloc logique reçoit les données des bits de rang $(p-1).2^{N-M} + i$ dans le mot numérique à transcoder, pour i variant de 1 à $2^{N-M}-1$, et en ce que le bit de rang $2^{N-M}$ de la deuxième matrice du code intermédiaire est obtenu directement par la valeur du bit de rang $N - M + 1$ dans le code binaire fourni par le deuxième module de décodage.

11. Convertisseur analogique/numérique comportant un décodeur selon l'une des revendications 6 à 10,
    caractérisé en ce que les dits blocs logiques sont réalisés sous la forme de portes analogiques à entrées multiples recevant sur des amplificateurs (T11,T12 ; T51,T52) des signaux analogiques différentiels, l'un de ces signaux (IN) étant un signal à mesurer, qui est comparé à une pluralité de références (Ref.1, Ref.5), chaque paire de signaux différentiels constituant un équivalent analogique d'un des signaux logiques précédemment mentionnés comme étant appliqués aux entrées de donnée des dits blocs logiques, (Li) en ce que chacune de ces portes analogiques inclut des moyens de forçage (T1, T2, R1, R2) en niveaux logiques du signal de sortie des dits amplificateurs et des moyens de mémorisation de ces niveaux logiques sur une sortie simple de la dite porte analogique à laquelle les sorties des amplificateurs sont réunies, et en ce que chaque porte analogique est munie d'entrées de sélection (SC1, SC5) pour la validation d'un des amplificateurs, les autres amplificateurs, non sélectionnés de cette porte présentant un état de haute impédance en sortie.

12. Convertisseur analogique/numérique selon la revendication 11,
    caractérisé en ce que les entrées des amplificateurs des portes analogiques sont connectées à des sorties des réseaux d'interpolation éventuellement reliées à des amplificateurs à repliement.

**Patentansprüche**

1. Ein Verfahren zur Datenumkodierung von digitalen Wörtern mit gleicher Anzahl Bits ($2^N$) nach einem thermometrischen Kodetyp, dessen aufeinanderfolgenden Werte in der Form einer ersten Matrix dargestellt werden können, von der jede Zeile ein digitales Wort ist,
   mit dem Merkmal, daß es eine definierte Zwischenkodierung verwendet, einerseits von einer zweiten Matrix ($M_1,\overline{M}_2, ... M'_1,\overline{M}'_2 ...$) , die der ersten Matrix entnommen wird und wobei eine Abmessung ein Unter-Vielfaches einer Abmessung der ersten Matrix ist, und andererseits aus einer dritten Matrix, deren Spalten bestimmte Spalten der ersten Matrix sind, die zeilenweise Gegenüberstellung der zweiten und dritten Matrix ermöglicht den Beibehalt der Gesamtheit der im anfänglichen thermometrischen Kode enthaltenen Information und bildet mit der ersten Matrix eine die besagte Zwischenkodierung definierende Umkodierungstabelle.

2. Ein Verfahren laut Anspruch 1, mit dem Merkmal, daß die zweite Matrix nach den aus folgendem bestehenden Schritte gebildet wird :

a) Auswahl in der ersten Matrix sogenannter dreieckiger Untermatrizen ($M_1$,$M_2$, ... $M'_1$,$M'_2$ ...), deren Abmessungen Unter-Vielfaches derer der ersten Matrix sind und mindestens eine Gesamtheit an entlang einer Diagonalen ausgerichteten Untermatrizen bilden,
b) Bildung der zweiten Matrix durch Stapelung, vertikal ausgerichtet, der sogenannten Untermatrizen.

3. Ein Verfahren laut Anspruch 2, mit dem Merkmal, daß die zweite Matrix zumindest teilweise zyklisch gemacht wird, indem zwischen den vorgenannten Schritten ein zusätzlicher Schritt eingefügt wird, der darin besteht, für die Hälfte der Untermatrizen ($M_2$,$M_4$, ... $M'_2$,$M'_4$ ...) und umgekehrt eine logische Umkehrung der Elemente dieser Untermatrizen vorzunehmen, vor ihrer ausgerichteten Stapelung.

4. Ein Verfahren laut einem der Ansprüche 1 bis 3, mit dem Merkmal, daß die Spalten (4,8,12,16) der dritten Matrix die der ersten Matrix sind, die dieselben Nummern wie die der Spalten der besagten dreieckigen Untermatrizen aufweisen, für die alle Elemente identisch sind.

5. Ein Verfahren laut einem der Ansprüche 1 bis 4, wobei N durch die Tatsache definiert wird, daß $2^N$ gleich der Anzahl Bits des umzukodierenden digitalen Worts ist (anfänglicher thermometrischer Kode), und

M durch die Tatsache definiert wird, daß $2^M$ gleich der Anzahl der besagten dreieckigen Untermatrizen ($M_1$, $M_2$, ... $M'_1$,$M'_2$ ...) ist, die sich entlang einer selben Diagonale der ersten Matrix befinden,
mit dem Merkmal, daß zur Umkodierung eines digitalen Worts in binären Kode ein Bit von Rang q des binären Kodes (Bit q) aus folgenden logischen Vorgängen entsteht, d.h. :

a) für $1 \leq q \leq N-M$, d.h. die (N-M) Bits geringen Gewichts des binären Kodes

$$\text{Bit } q = \sum_{p=1}^{2^{N-M-q}} \left[ \sum_{i=1}^{2^{q-1}} D_{(p.2^q-i)} \oplus D_{(p.2^q-i+1)} \right]$$

D(x) bezeichnet die in der Spalte von Rang x der ersten Matrix enthaltenen Daten,
b) für $1+N-M \leq q \leq N$, d.h. die M Bits großen Gewichts des binären Kodes :

$$\text{Bit } q = \sum_{p=1}^{2^{N-q}} \left[ \sum_{i=1}^{2^{q-N+M-1}} D'_{(p.2^{q-N+M}-i).2^{N-M}} \oplus D'_{(p.2^{q-N+M}-i+1).2^{N-M}} \right]$$

D'(x) bezeichnet die in der Spalte von Rang x der dritten Matrix enthaltenen Daten,
c) und im Falle der anfängliche thermometrische Kode zu $2^N$ Bits zyklisch ist, wird das N+1. Bit des binären Kodes direkt erhalten durch :

$$\text{Bit N+1} = D'_{(2^N)}$$

d.h. das Bit, dessen Gewicht im digitalen, umzuwandelnden Wort am meisten Gewicht hat.

6. Ein Dekodierer für die Umsetzung des Verfahrens laut einem der Ansprüche 1 bis 5, mit dem Merkmal, daß er über Mittel zur Umkodierung von Eingangssignalen in eine Zwischenkodierung verfügt, in dem eine zweite Matrix ($M_1$,$\overline{M}_2$, ... ,$M'_1$,$\overline{M}'_2$) der ersten Matrix zu einer zur Dimension der ersten Matrix unter-vielfachen Dimension entnommen wird, und in dem eine dritte Matrix über Spalten verfügt, die zumindest teilweise von den Spalten der ersten Matrix gebildet sind, wobei die Mittel bestehen aus :
In einem ersten Dekodierungsmodul (400) für die Dekodierung der binären Ausgangskodierung der Bits geringen Gewichts einer erste Gesamtheit Tore (110, 120, 130, D1, 210, 220, 230, D2 ...), aufgeteilt in ähnliche Gruppen, sogenannte logische Blöcke ($L_1$, ... $L_i$, ... $L_j$), mit k Dateneingängen, die mit k Auswahleingängen verbunden sind, die logischen Blöcke liefern an ihren Ausgängen Signale, die die Eingangsdaten nach einer Zwischenkodierung ausdrücken, deren Werte die zweite Matrix prüfen, und die Zahl k ist gleich der Anzahl der sogenannten Untermatrizen ($M_1$,$M_2$, ... $M'_1$,$M'_2$ ...), von denen von der zweiten Matrix Untermatrizen entnommen werden, entlang einer selben Diagonale der ersten den thermometrischen Kode darstellenden Matrix ausgerichtet, und in einem zweiten Dekodierungsmodul für die Dekodierung von Bits großen Gewichts (400) einer zweiten Gesamtheit an Toren ($D'_4$,$D'_8$ ... $D'_j$...) einfachen Eingangs, die an ihrem Ausgang andere, die Bits des Eingangssignals darstellende Signale liefern, die den Wert nur ändern, wenn im Rahmen der ersten Matrix von einer Untermatrix auf eine andere gewechselt wird und die die dritte Matrix der Umkodierungstabelle entsprechend der Zwischenkodierung prüfen, das zweite Dekodierungsmodul liefert zugleich Auswahlsignale (SC), die jeweils einem der k Auswahleingänge der logischen Blöcke ($L_1$, ... $L_i$, ... $L_j$) zugeführt werden und die der Aktivierung der Eingangsdaten dieser logischen Blöcke dienen.

7. Ein Dekodierer laut Anspruch 6, mit dem Merkmal, daß der p. Auswahleingang jedes der logischen Blöcke (Li) das logische, sich aus einem exklusiven ODER ergebende Signal zwischen den Bits von Rang $p.2^{N-M}$ und von Rang $(p-1).2^{N-M}$ in einem digitalen, umzukodierenden Wort erhält, während p einen der Werte des Intervalls 2 bis $2^M$ (einschließlich 2 und $2^M$) annimmt, und das logische, sich aus dem exklusiven ODER am umkehrenden Ausgang zwischen den Bits von Rang $2^{N-M}$ und von Rang $2^N$ in dem umzuwandelnden, digitalen Wort ergebende Signal erhält, wenn p gleich 1, wobei N und M der Definition von Anspruch 5 entsprechen.

8. Ein Dekodierer laut Anspruch 7, mit dem Merkmal, daß die Anzahl logischer Blöcke (Li) gleich $2^{N-M}$ ist und daß der p. Dateneingang des i. logischen Blocks die Datenbits von Rang $(p-1).2^{N-M}+i$ in dem umzuwandelnden digitalen Wort erhält, wobei i von 1 bis $2^{N-M}$ variiert.

9. Ein Dekodierer laut Anspruch 7 für die Umkodierung von Daten, die nach einer zyklischen thermometrischen Kodierung auftreten, wobei der Dekodierer logische Blöcke (Li) aufweist, die so angeordnet sind, daß ihr p. Dateneingang am Ausgang ein umgekehrtes logisches Signal liefert, wenn der Wert p gerade ist,
mit dem Merkmal, daß die Anzahl logischer Blöcke gleich $2^{N-M}-1$ ist, daß der p. Dateneingang des i. logischen Blocks die Datenbits von Rang $(p-1).2^{N-M}+i$ in dem umzuwandelnden digitalen Wort erhält, wobei i von 1 bis $2^{N-M}-1$ variiert, und, daß das Bit von Rang $2^{N-M}$ der zweiten Matrix des Zwischenkodes am Ausgang eines ausschließlichen ODER-Tors erhalten wird, das am Eingang die logischen Daten enthält, die gleich den Bits von Rang $N-M+1$ und von Rang $N+1$ des binären Kodes sind, die vom zweiten Dekodierungsmodul (500) geliefert werden.

10. Ein Dekodierer laut Anspruch 7 für die Umkodierung von Daten, die nach einer zyklischen thermometrischen Kodierung auftreten, wobei der Dekodierer logische Blöcke (Li) aufweist, die so angeordnet sind, daß ihr p. Dateneingang am Ausgang ein umgekehrtes logisches Signal liefert, wenn der Wert p gerade ist, mit dem Merkmal, daß die Anzahl logischer Blöcke (Li) gleich $2^{N-M}-1$ ist, daß der p. Dateneingang des i. logischen Blocks die Datenbits von Rang $(p-1).2^{N-M}+i$ in dem umzuwandelnden digitalen Wort erhält, wobei i von 1 bis $2^{N-M}-1$ variiert, und, daß das Bit von Rang $2^{N-M}$ der zweiten Matrix des Zwischenkodes direkt über den Wert des Bits von Rang $N-M+1$ im binären Kode erhält, der vom zweiten Dekodierungsmodul geliefert wird.

11. Eine Analog/Digital-Umkodierungseinrichtung mit einem Dekodierer laut einem der Ansprüche 6 bis 10, mit dem Merkmal, daß die besagten logischen Blöcke in der Form analoger Tore mit Vielfacheingängen verwirklicht werden, die an Verstärkern (T11, T12; T51, T52) differentielle analoge Signale erhalten, wobei eines dieser Signale (IN) ein mit einer Vielzahl Referenzen (Ref.1, Ref.5) verglichenes Meßsignal ist, jedes differentielle Signalpaar bildet einen analogen Gegenwert eines der zuvor erwähnten Signale zur Zuführung zu den Dateneingängen der besagten logischen Blöcke (Li), daß jedes dieser analogen Tore über Mittel zur Erzwingung (T1, T2, R1, R2) auf logisches Niveau des Ausgangssignals der besagten Verstärker und Mittel zur Speicherung dieser logischen Niveaus an einem einfachen Ausgang des besagten analogen Tors verfügt, an dem die Ausgänge der Verstärker zusammenkommen, und, daß jedes analoge Tor mit Auswahleingängen (SC1, SC5) für die Aktivierung eines Verstärkers versehen ist, während die anderen, nicht gewählten Verstärker dieses Tors einen Zustand hoher Impedanz am Ausgang aufweisen.

12. Eine Analog/Digital-Umkodierungseinrichtung laut Anspruch 11, mit dem Merkmal, daß die Eingänge der Verstärker der analogen Tore an die Ausgänge der Interpolationsnetze angeschlossen sind, die eventuell mit eingezogenen Verstärkern verbunden sind.

**Claims**

1. Method of transcoding data expressed in digital words of like number ($2^N$) of bits according to a thermometric type of coding, the successive values of which can be represented in the form of a first matrix of which each row is a digital word, characterised in that it uses an intermediate code defined, on the one hand, by a second matrix ($M_1$, $\overline{M}_2$, $M'_1$, and $\overline{M}'_2$) which is extracted from the first matrix and has a dimension which is a sub-multiple of a dimension of the first matrix, and on the other hand, by a third matrix which has columns formed by particular columns of the first matrix, the row-by-row juxtaposition of the second and third matrices enabling all the information present in the thermometric starting code to be preserved and, together with the first matrix, forming a conversion table which defines said intermediate code.

2. Method as claimed in Claim 1, characterised in that the second matrix is constructed following the steps consisting of :

    a) selecting from the first matrix, so-called triangular sub-matrices ($M_1$, $M_2$, --- $M'_1$, $M'_2$ ---) whose dimensions are sub-multiples of those of the first matrix forming at least one set of sub-matrices aligned along a diagonal,
    b) producing the second matrix by a vertically aligned stacking of the said sub-matrices.

3. Method as claimed in Claim 2, characterised in that the second matrix is rendered at least partly cyclic by interposing between the abovementioned steps, an additional step consisting of carrying out, for half of the sub-matrices ($M_2$, $M_4$, --- $M'_2$, $M'_4$ ---) and alternately, a logical inversion of the elements of these sub-matrices prior to their aligned stacking.

4. Method as claimed in one of Claims 1 to 3, characterised in that the columns (4, 8, 12,16) of the third matrix are those of the first matrix which have the same numeral as that of the columns of said triangular sub-matrices for which all the elements are identical.

5. Method as claimed in one of Claims 1 to 4, in which N is defined by the fact that $2^N$ is equal to the number of bits of the digital word to be transcoded (thermometric starting code), M is defined by the fact that $2^M$ is equal to the number of said triangular sub-matrices ($M_1$, $M_2$, --- $M'_1$, $M'_2$ ---) present along the same diagonal of the first matrix, characterised in that, for the transcoding of a digital word into a binary code, a bit of order q of the binary code (Bit q) results from the following logical operations :

    a) for $1 \leq q \leq N-M$, that is, the (N-M) least significant bits of the binary code

$$\text{Bit } q = \sum_{p=1}^{2^{N-M-q}} \left[ \sum_{i=1}^{2^{q-1}} D_{(p.2^q-i)} \oplus D_{(p.2^q-i+1)} \right]$$

    $D_{(x)}$ designating the datum contained in the order x column of the first matrix,
    b) for $1 + N-M \leq q \leq N$, that is, the M most significant bits of the binary code

$$\text{Bit } q = \sum_{p=1}^{2^{N-q}} \left[ \sum_{i=1}^{2^{q-N+M-1}} D'_{(p.2^{q-N+M}-i).2^{N-M}} \oplus D'_{(p.2^{q-N+M}-i+1).2^{N-M}} \right]$$

    $D'_x$ designating the data contained in the order x column of the third matrix,
    c) and for the case where the thermometric starting code with $2^N$ bits is cyclic, the N+1$^{st}$ bit of the binary code is obtained directly through :

$$\text{Bit } N + 1 = D'_{(2^N)}$$

    that is to say, the most significant bit in the digital word to be transcoded.

6. Decoder for employing the method as claimed in one of the Claims 1 to 5, characterised in that it includes transcoding means for transcoding input signals into an intermediate code, in which a second matrix ($M_1$, $\overline{M}_2$, $M'_1$ and $\overline{M}'_2$) is extracted from the first matrix and has a dimension which is a sub-multiple of a dimension of the first matrix, and in which a third matrix has columns formed by particular columns of the first matrix, which means comprise:

in a first decoding module (400) for decoding least significant bits of the binary output code, a first set of gates (110, 120, 130, D1, 210, 220, 230, D2 ...) spread over identical groups called logic blocks ($L_1,...,L_i,...L_j$) which have k data inputs associated to k selection inputs, which logic blocks produce on their output signals which are expressed as input signals according to the intermediate code whose values verify the second matrix, and the number k is equal to the number of sub-matrices called triangular sub-matrices ($M_1$, $\overline{M}_2$, $M'_1$ and $\overline{M}'_2$) from which are extracted sub-matrices of the second matrix, aligned along the same diagonal of the first matrix representing the thermometric code,

and in a second decoding module (400) for decoding most significant bits of the binary output code, a second set of gates ($D'_4$, $D'_8$,...$D'_j$...) with a single input which produce on the output other signals which express those input signal bits whose value changes only when a change is made from one sub-matrix to another in the first matrix, and verify the third matrix of the conversion table in conformity with the intermediate code, which second decoding module also produces selection signals (SC) of which each one is applied to one of the k selection inputs of the logic blocks ($L_1,...,L_i,...L_j$) and which are intended to enable the data inputs of these logic blocks.

7.  Decoder as claimed in Claim 6, characterised in that the $p^{th}$ selection input of each of the logic blocks (Li) receives the logic signal resulting from an exclusive-OR between the order $p.2^{N-M}$ and order $(p-1).2^{N-M}$ bits in the digital word to be transcoded, when p takes one of the values from the interval 2 to $2^M$ (including 2 and $2^M$), and the logic signal resulting from an exclusive OR with inverting output between the order $2^{N-M}$ and order $2^N$ bits in the digital word to be transcoded, when p is equal to 1, and for N and M such as defined in Claim 5.

8.  Decoder as claimed in Claim 7, characterised in that the number of logic blocks (Li) is equal to $2^{N-M}$, and in that the $p^{th}$ data input of the $i^{th}$ logic block receives the data of the order $(p-1).2^{N-M}+i$ bits in the digital word to be transcoded, for i varying from 1 to $2^{N-M}$.

9.  Decoder as claimed in Claim 7, for the transcoding of data appearing through a cyclic thermometric coding and which decoder having logic blocks (Li) which are arranged such that their $p^{th}$ data input delivers at output an inverted logic signal when the value of p is even, characterised in that the number of logic blocks is equal to $2^{N-M-1}$, in that the $p^{th}$ data input of the $i^{th}$ logic block receives the data of the order $(p-1).2^{N-M}+i$ bits in the digital word to be transcoded, for i varying from 1 to $2^{N-M-1}$, and in that the order $2^{N-M}$ bit of the second matrix of the intermediate code is obtained at the output of an exclusive-OR gate receiving as input the logic data equal to the order $N-M+1$ and order $N+1$ bits of the binary code which are delivered by the second decoding module.

10. Decoder as claimed in Claim 7, for the transcoding of data appearing through an acyclic thermometric coding and which decoder has logic blocks (Li) which are arranged such that their $p^{th}$ data input delivers as output an inverted logic signal when the value of p is even, characterised in that the number of logic blocks (Li) is equal to $2^{N-M-1}$, in that the $p^{th}$ data input of the $i^{th}$ logic block receives the data of the order $(p-1).2^{N-M}+i$ bits in the digital word to be transcoded, for i varying from 1 to $2^{N-M-1}$, and in that the order $2^{N-M}$ bit of the second matrix of the intermediate code is obtained directly through the value of the N-M+1 -order bit in the binary code delivered by the second decoding module.

11. Analog/digital converter including a decoder as claimed in one of Claims 6 to 10, characterised in that the said logic blocks are produced in the form of analog gates with multiple inputs receiving differential analog signals on amplifiers (T11, T12; T51, T52), one of these signals (IN) being a signal to be measured, which is compared with a plurality of references (Ref1, Ref5), each pair of differential signals constituting an analog equivalent of one of the logic signals previously mentioned as being applied to the data inputs of said logic blocks (Li), in that each of these analog gates includes means (T1, T2, R1, R2) for setting the logic levels of the output signal from said amplifiers and means for storing these logic levels on a single output of said analog gate at which the outputs of the amplifiers are joined, and in that each analog gate has selection inputs (SC1, SC5) in order to enable one of the amplifiers, the other amplifiers, not selected, of this gate exhibiting a high-impedance state at the output.

12. Analog/digital converter as claimed in Claim 11, characterised in that the inputs of the amplifiers of the analog gates are connected to outputs of interpolation networks, which outputs are linked, as required, to folding amplifiers.

FIG.1

FIG.2

FIG.3

FIG.4

FIG.5

FIG.6

FIG.7

FIG.8